# EUROPEAN PATENT SPECIFICATION

(11) **EP 4 423 912 B1**
(45) Date of publication and mention of the grant of the patent: **22.04.2026**
(21) Application number: 22808822.5
(22) Date of filing: 26.10.2022
(51) Int. Cl.: H03K 17/80, H03K 17/04, H03K 17/0412, H03K 17/13, H02M 1/08, H02M 1/00, H02M 3/00

(54) **GATE UNIT FOR A GATE-COMMUTATED THYRISTOR AND INTEGRATED GATE-COMMUTATED THYRISTOR**
GATE-UNIT FÜR EINEN GATE-KOMMUTIERTEN THYRISTOR UND INTEGRIERTER GATE-KOMMUTIERTER THYRISTOR
UNITÉ DE GRILLE POUR UN THYRISTOR À COMMUTATION DE GRILLE ET THYRISTOR À COMMUTATION DE GRILLE

(30) Priority: 28.10.2021 EP 21205354
(43) Date of publication of application: 04.09.2024
(73) Proprietor: ECOLE POLYTECHNIQUE FEDERALE DE LAUSANNE (EPFL), 1015 Lausanne (CH)
(72) Inventor: KUCKA, Jakub, 1024 ECUBLENS VD (CH); DUJIC, Drazen, 1094 PAUDEX (CH)
(74) Representative: Banse & Steglich Patentanwälte PartmbB
(86) International application number: PCT/EP2022/079995
(87) International publication number: WO 2023/073051

(56) References cited:
- EP-A2- 0 416 933
- EP-A2- 1 235 334
- STIELAU O H ET AL: "A high performance gate/base drive using a current source", CONFERENCE RECORD OF THE INDUSTRY APPLICATIONS SOCIETY ANNUAL MEETING. SEATTLE, OCT. 7 - 12, 1990; [CONFERENCE RECORD OF THE INDUSTRY APPLICATIONS SOCIETY ANNUAL MEETING], NEW YORK, IEEE, US, 7 October 1990 (1990-10-07), pages 1637, XP032134194, ISBN: 978-0-87942-553-1, DOI: 10.1109/IAS.1990.152406

## Description

### Technical field

The present invention relates to soft-switching power electronics devices which utilize IGCTs as a semiconductor switch. Particularly, the present invention relates to gate units for gate commutated thyristors that are particularly suited for soft-switching applications.

### Technical background

Integrated-gate commutated thyristors (IGCT) are thyristor-based semiconductor switching devices that integrate a gate commutated thyristor (GCT) and a gate unit for controlling the switching of the GCT in a single switching module.

In high-power medium-voltage applications, IGCTs have proven to achieve remarkable efficiencies and high-power density. Furthermore, these power switches proved to be robust and reliable, and come with typically very high voltage and current ratings, making them suitable for MW level power conversion. Typically, these devices have very low conduction losses, being another reason for their use in high power applications. However, IGCTs have high switching losses which effectively limits their efficiency and the applicable switching frequencies. Typically, IGCT devices are switched with frequencies below 1kHz in industrial converters, which are in most cases AC-DC hard-switched rectifiers or inverters. Consequently, state of the art gate units are designed for hard-switched low frequency operation.

Power stages of gate units for hard-switching applications are exemplarily known from H. Gruening et al., "6 kV 5 kA RCGCT with advanced gate drive unit," Proceedings of the 13th International Symposium on Power Semiconductor Devices & ICs. IPSO '01 (IEEE Cat. No.01CH37216), 2001, pp. 133-136, and L. Xie et al., "The design of IGCT Gate-Unit equipped in the three-level NPC converter," 2011 International Conference on Electrical Machines and Systems, 2011, pp. 1-6, wherein the gate units has separate stages such as a turn-on and retrigger stage, a turn-off stage, a positive gate voltage backporch channel stage and a negative gate voltage backporch channel stage.

To reduce the GCT switching losses, soft-switching can be applied. Soft-switching implies additional measures and can be generally realized as zero-current switching (ZCS) or zero-voltage switching (ZVS). In the ZCS operation, the device's current (anode-cathode-current) is close to zero immediately before and after the switching instant happens. In contrast, in the ZVS operation, the device's blocking voltage (anode-cathode-voltage) is close to zero immediately before and after the switching instant happens. Since the switching loss of a device is roughly proportional to the product of the conducting current and blocking voltage, both ZVS and ZCS enable very low switching losses for the device.

Document EP 1235334 A1 discloses a gate driver for driving a thyristor having an an-ode, a cathode and a gate by providing a gate current to the gate of said thyristor during an on-command signal is present, said gate driver comprises a turn-on pulse generator for generating a turn-on pulse in response to a leading edge of said on-command signal; a down converter for producing a down slope current immediately following said firing pulse; and a current limiter having a MOSFET connected to the gate of said thyristor for supplying current from said down converter to the gate of said thyristor, said current limiter monitoring the gate voltage at the gate of said thyristor and increasing an internal resistance of said MOSFET relatively to the negative voltage increase of said gate voltage.

It is an object of the present invention to provide an improved gate unit for a gate-commutated thyristor (GCT) with a reduced circuitry and switching losses.

### Summary of the invention

This object is achieved by the gate unit for a gate-commutated thyristor according to claim 1 and the method for operating a gate-commutated thyristor according to claim 13.

Further embodiments are indicated in the dependent subclaims.

According to a first aspect, a gate unit for controlling a gate commutated thyristor is provided, comprising:
- a voltage selector for selectively applying a high supply potential, a middle supply potential, and a low supply potential;
- a nonlinear inductor serially coupled between the output of the voltage selector;
- a gate control unit configured to control the voltage selector to control switching of the gate commutated thyristor in its turn on state, wherein the turn-on states comprise a turn-on pulse generation, a positive-gate-voltage backporch operation, a negative-gate-voltage backporch operation and a retrigger pulse generation;
wherein the nonlinear inductor has a nonlinearity to have a high inductance during any of the backporch operations and to have a low inductance during the turn-on pulse generation and retrigger pulse generation.

As described before, the gate unit and the IGCT will be used in applications where they can be operated in a zero-current switching or zero-voltage switching operation mode.

Particularly, IGCTs can be applied in applications, such as an LLC resonant converter with a zero-voltage switching during turn-on or a series resonant converter with a zero-current switching during turn-on.

Basically, for accomplishing switching, particularly for hard-switching, gate units for IGCTs are generally designed to implement the following functions which are conventionally implemented in separate hardware stages:
- Turn off - a negative voltage is applied between a gate and an anode of the GCT to remove free charges and commutate the load current onto the gate unit to restore blocking capability of the IGCT.
- Turn on pulse generation - a high current pulse with a high current slope di/dt is applied to the gate of the GCT to ensure that all thyristor cells of the GCT are opened uniformly before the conduction current of the GCT starts to rise.
- Positive-gate-voltage backporch operation - a low current is supplied to the gate unit to ensure that the thyristor cells remain in the on-state.
- Negative-gate-voltage backporch operation - a low current is supplied to keep the IGCT turned-on, while its antiparallel diode which may be external or integrated in reverseconducting IGCT is conducting. This kind of operation is different from the usual positive-gate-voltage-backporch operation because the gate voltage of the GCT is negative which implies power flow into the gate unit.
- Retrigger pulse generation- after the antiparallel diode stopped conducting in "negative-gate-voltage backporch operation", it has to be ensured that all thyristor cells are ready to conduct current by applying a high current pulse to the gate. This high current pulse resembles the turn ON pulse.

According to the invention, the gate control unit is configured to operate switching of the gate commutated thyristor in soft-switching mode, particularly in a zero voltage switching mode or a zero current switching mode.

Although some integration is possible most of these functions are implemented by dedicated power stages due to the power requirements. As a result, the gate unit is relatively complex, which affects its size that poses practical restrictions on the mechanical construction of the IGCT stack and increases the overall cost.

On the other hand, in the considered soft-switching applications, the IGCT is either nonconducting after the turn on (in ZVS operation), or the current builds up very slowly after the turn on (in ZCS operation). Moreover, in the typical resonant ZVS operation, the current rate of rise (current slope) is also limited when the retrigger pulse is required. As a consequence, there is significantly more time for the thyristor cells of the IGCT to open uniformly and thus, both the turn-on pulse and the retrigger pulse can be reduced in magnitude. This reduction in peak current ratings reduces power flow during switching and, therefore, directly reduces the cost of these power stages.

Because of these reduced requirements implied in the soft-switching applications, there is a possibility to integrate above functions of turn-on pulse generation, positive gate-voltage-backporch operation, negative-gate-voltage backporch operation, and retrigger pulse generation into a single power stage.

Furthermore, a turn-off stage may be provided configured to apply the negative supply potential to selectively turn off the GCT. The result of such integration lies in a lower number of components resulting in a reduced size and lower costs of the gate unit. This has a substantial positive effect on the reliability of the system as a whole.

The central idea of the invention is to integrate the turn-on function, the retrigger function, the positive-gate-voltage backporch function, and the negative-gate-voltage backporch function into a single power stage. This is possible because in the applications with ZVS or ZCS turn on, the current slope di/dt of the anode current after turning on (or retrigger pulse generation) is very low. Hence, the thyristor cells within the GCT have significantly more time to open uniformly without causing hot-spotting problems (a nonuniform distribution of current in the wafer, potentially leading to a GCT failure). As a consequence, the turn-on and retrigger pulses can be reduced in magnitude. This opens the possibility for the simplification of the gate unit.

The power stage may comprise a transistor-switched voltage selector, such as a T-type NPC stage, e.g. formed by four MOSFETs, whose output is coupled with a single nonlinear saturable inductor. The power stage may be controlled by a gate control unit and may be operated to accomplish functions of the conventional turn-on stage, the retrigger stage, the positive-gate-voltage backporch stage and the negative-gate-voltage backporch stage capable of connecting a high supply voltage potential, a middle supply voltage potential and a low supply voltage potential in a controlled manner. The output of the transistor-switched voltage selector is coupled via the nonlinear inductor with a gate terminal of the GCT. The transistor-switched voltage selector can be used to have complete control over the turn-on states by adjusting the voltage drop over the nonlinear inductor.

The inductor is configured as a nonlinear inductor which may actively be driven into saturation or operated in saturation. At low currents the inductor is not yet saturated and provides an inductance for backporch operation modes which is sufficiently high so that the current ripple is reasonably low while maintaining reasonably low switching frequencies. During high currents, the inductor should saturate and, therefore, decrease its inductance to enable higher current slopes di/dt of the turn-on and retrigger pulses.

This nonlinear characteristic also decreases the energy which can be stored in the inductor during the turn-on and the retrigger pulse generation. Therefore, the inductor size can be made smaller and the pulse loading of the high-supply voltage bus is lower. In contrast to using multiple inductors for current pulse shaping as known from prior art, the use of a single nonlinear saturable inductor simplifies the topology of the gate unit significantly. The power stage is capable to support the combined operation modes, such as turn-on, positive voltage backporch operation, negative gate voltage backporch operation and retrigger operation as follows:
- TURN OFF: During turn OFF, the gate terminal of the GCT is connected with the low supply potential while the voltage selector supplies the low supply potential to ensure that the inductor current does not increase. This current slowly decreases via parasitic resistances.
- TURN ON: While the GCT is still in the off state, i.e. the gate terminal of the GCT remains connected with the low supply potential, the voltage selector is controlled to supply a high or middle voltage supply potential to increase the inductor current in the nonlinear inductor to the required value. After a certain time delay, the low supply potential at the gate terminal may be removed and the gate current is fully commutated into gate terminal of the GCT. This generates a high current pulse. After the inductor current has been commutated into the gate terminal, the middle supply potential is kept to ensure that that the gate current declines if gate-to-cathode voltage is identified as positive. If gate-to-cathode voltage is identified as negative, the low supply potential is applied to actively decrease the gate current. Once the gate/inductor current has decayed to a defined threshold the corresponding backporch operation is activated (according to the identified gate-to-cathode voltage)
- POSITIVE-GATE-VOLTAGE BACKPORCH OPERATION: This operation is applied as long as the identified gate-to-cathode voltage is positive. The gate/inductor current is controlled via pulses generated by two switching states of the voltage selector, i.e. high supply potential and middle supply potential. A possible control is a hysteresis control or a fixed turn-on time control.
- NEGATIVE-GATE-VOLTAGE BACKPORCH OPERATION: This operation is applied as long as the identified gate-to-cathode voltage is negative. The current is controlled via pulses generated by two switching states of the voltage selector, i.e. middle supply potential and low supply potential. A possible control is a hysteresis control or a fixed turn-on time control.
- retrigger pulse generation: A retrigger pulse is generated by applying the high supply potential by the voltage selector to ramp up the inductor current in the nonlinear inductor. Once the required current is reached, the middle supply potential is applied to let the gate current decay.

It may be provided that the nonlinearity of the nonlinear inductor is selected so that the low inductance for the turn-on pulse generation has a value at least 50% lower than the high inductance during the backporch operation. While the high inductance value might be a clear requirement to achieve ripple sufficiently low, the low value of inductance can be selected slightly more freely.

It may be provided that the gate unit comprises a communication channel output to interlink with a control input of another gate unit wherein the gate control unit is configured to propagate a control signal received via the control input through the communication channel output, wherein the control signal includes switching commands for the gate commutated thyristors.

Moreover, the gate unit may comprise a communication channel output to interlink with a control input of another gate unit wherein the gate control unit is configured to propagate an control signal received via the control input through the communication channel output, wherein the control signal includes an error signal indicating the occurrence of an error in one of the gate units wherein the gate control unit is further configured to halt operation of the gate unit once an error signal has been received.

According to a further aspect, an integrated gate commutated thyristor (IGCT) comprising a gate commutated thyristor and the above gate unit is provided.

According to a further aspect, a converter stage for use in a converter system is provided, comprising a number of integrated gate commutated thyristors each including a gate commutated thyristor and the above gate unit, wherein one of the gate units is coupled with a central controller to receive the control signal and at least a part of the other gate units are respectively coupled via its communication channel output with the control input of a further one of the other gate units, so that the control signal is available in all gate units.

### Brief description of the drawings

Embodiments are described in more detail in conjunction with the accompanying drawings, in which:
- Figure 1: schematically shows an LLC resonant converter configured for zero-voltage switching during turn-on.
- Figure 2: shows a circuitry for illustrating the design of the gate unit for the gate-commutated thyristors.
- Figure 3: shows an example characteristics of the nonlinear inductor used in the power stage of the gate unit.
- Figure 4: shows a system of gate units with an interlock function for error handling.
- Figure 5: shows a further system of gate units with an interlink function for switching control.

### Description of embodiments

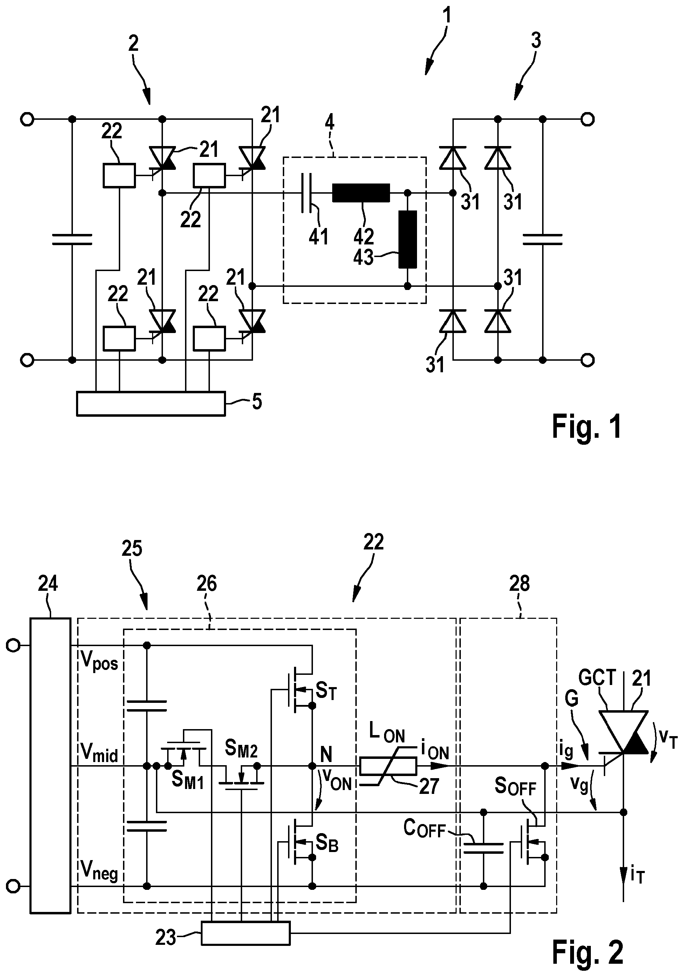

Figure 1 schematically shows circuitry for an LLC resonant converter 1 with an active inverter stage 2, a resonant tank 4, and a rectifier stage 3. The inverter stage 2 comprises a bridge circuit of four gate-commutated thyristors 21 (GCT), each controlled by an individual gate unit 22 for operating or controlling the switching the GCT 21.

The gate units 22 are controlled by a central controller 5 for converter operation by commanding switching on or switching off of each of the GCTs. Switching on and off of the GCTs 21 is handled by the corresponding gate units 22.

The inverter stage 2 is made of two separate inverter series connections of GCTs 21 which are coupled with the resonant tank 4 via their middle nodes. The resonant tank 4 comprises a series connection of a first capacitor 41 and a first inductance 42 at a first of the middle nodes wherein a second inductance 43 connects the series connection with a second of the middle nodes of the inverter stage 2. Furthermore, the resonant tank 4 is coupled with the rectifier 3, e.g. implemented as a passive diode rectifier with diodes 31.

The central controller 5 is capable of operating the LLC resonant converter 1 in a zero-voltage switching or zero-current switching mode to improve the efficiency of converter 1. In the following, it is assumed that converter 1 is configured to be operated in the zero-voltage switching mode or zero-current switching mode, as in these operation modes, the value of the current slope di/dt of the anode current after turn-on pulse is relatively low. For the implementation of the zero-voltage switching mode or the zero-current switching mode appropriate voltage and/or current measurement units for measuring cathode-anode voltage /current are implemented in the IGCT formed by the respective GCT 21 and gate unit 22.

Figure 2 schematically shows the circuitry of one of the gate units 22 in more detail. Each gate unit 22 has a similar or identical configuration.

The gate unit 22 uses a power supply 24 which generally provides three supply voltage potential levels, such as a high supply potential Vₚₒₛ, a middle supply potential V_{mid} and a negative supply potential V_{neg}. The power supply 24 of the gate unit may be powered by an (not shown) external medium-voltage-isolating power supply.

A power stage 25 is connected with the power supply 24 basically comprises a voltage selector 26 comprising switching transistors, such as MOSFETs, to connect one of the supply potentials Vₚₒₛ, V_{mid}, V_{neg} to a selector output node N. The selector output node N is coupled with a nonlinear inductor 27 to the gate unit output G to be applied to a respective gate terminal of the GCT 21.

In detail, a first switching transistor S_{T} is coupled between the high supply potential Vₚₒₛ and the selector output node N, the middle supply potential V_{mid} is coupled via two switching transistors S_{M1}, S_{M2} with the selector output node N, and the low supply potential V_{neg} is coupled via a fourth switching transistor S_{B} with the selector output node N. The selector output node N is coupled via the nonlinear inductance 27 with the gate unit output G.

For the correct operation, measurement units for measuring the gate-to-cathode voltage polarity (e.g. by comparators) and the inductor current have to be provided.

When controlling the switching transistors, the first and second switching transistors S_{T}, S_{M1} are operated complementary and the third and fourth switching transistors S_{M2}, S_{B} are operated complementary. Control of the switching transistors S_{T}, S_{M1}, S_{M2}, S_{B} is made by a gate control unit 23. To connect the high supply potential Vₚₒₛ with the selector output node N, only the first switching transistor S_{T} is switched on, while the others are switched off, to connect the middle supply potential V_{mid} with the selector output node N, the second and third switching transistors S_{M1}, S_{M2} are switched on, while the others are switched off, and to connect the low supply voltage V_{neg} with the selector output node N, only the fourth switching transistor S_{B} is switched on, while the other switching transistors S_{T}, S_{M1}, S_{M2} are switched off. This allows having complete control over the turn-on current at the gate unit output G, which is applied to the gate of the GCT 21.

Hence, the voltage selector 26 of the power stage has a three-level T-type NPC topology and is configured to provide three voltage levels at the selector output node N.

Furthermore, there is a turn-off stage 28 configured to turn off the GCT 21 and to keep it off by applying the negative supply potential V_{neg} between its gate terminal and its cathode terminal. This is made with a turn-off transistor S_{off} also controlled by the gate control unit 23. So, the turn-off stage 28 has the task to connect the gate terminal of the GCT 21 with the low supply potential V_{neg} to discard the charge from the gate terminal in order to turn off the GCT 21. During the turn-off process, the inductor current iₒₙ is completely commutated into gate unit 22 for the GCT 21 to restore its blocking capability. Therefore, the low supply potential V_{neg} is buffered by a sufficiently high capacitance C_{off}.

The control method applied by the gate control unit 23 is as follows:
- Turn off: During turn-off (turn off transistor S_{off} is conductive), the voltage selector 26 is controlled to select the low supply potential V_{neg} to ensure that an inductor current iₒₙ does not increase. This current slowly decreases via parasitic resistances.
- Turn on: In the turn-on operation, the turn-off state (i.e. the conductive S_{off}) is not deactivated immediately, but first it is actively used to build up the current in the nonlinear inductor 27 together with the activated power stage. In other words, while the GCT 21 is still in the turn off state (transistor S_{off} is conductive), the voltage selector 26 is controlled to select the high supply potential Vₚₒₛ or the middle supply potential V_{mid} to increase the inductor current iₒₙ of the inductor 27 to the required value. The required value is defined by the application and GCT technology - e.g. between 20 -80 A. After a certain time delay, the turn-off transistor S_{off} is deactivated and the inductor current iₒₙ is fully commutated as gate current i_{g} into the gate terminal. This generates a high current pulse. After the inductor current iₒₙ has been commutated into gate, the middle supply potential V_{mid} is kept to ensure that that the gate current i_{g} declines if a gate-to-cathode voltage V_{GC} is identified as positive. If gate-to-cathode voltage is identified as negative, the low supply potential is applied to actively decrease the gate current. Once the gate current i_{g} has decayed to a defined threshold the corresponding backporch operation is activated (according to an identified/measured gate-to-cathode voltage V_{GC} of the GCT 21).
- positive-gate-voltage backporch operation: This operation is applied after turning on operation has been finished as long as the identified gate-to-cathode voltage V_{GC} is positive. The gate current i_{g} is controlled via pulses generated by two switching states of the voltage selector Vₚₒₛ, V_{mid}. A possible control is a hysteresis control or a fixed turn-on time control.
- Negative-gate-voltage backporch operation: This operation is applied as long as the identified gate-to-cathode voltage V_{GC} is negative. It can be provided that the backporch gate current i_{g} is increased, when the gate voltage v_{g} becomes negative in order to accelerate the build-up of the retrigger pulse. The gate current i_{g} is controlled via pulses generated by two switching states of the voltage selector V_{neg}, V_{mid}. This is possible because the excessive energy during this kind of operation is not dissipated, but it is recuperated into the capacitor C_{off}. A possible control is a hysteresis control or a fixed turn-on time control.
- retrigger pulse generation: When in the negative-gate voltage backporch operation the gate-to-cathode voltage V_{GC} becomes positive again, a retrigger pulse is generated by applying a high supply potential Vₚₒₛ by the voltage selector 26 to ramp up the inductor/gate current i_{g} in the nonlinear inductor 27. Once the required value of the current is reached, the middle supply potential V_{mid} is applied to let the gate current i_{g} decay. The required value is defined as above by the application and GCT technology - e.g. between 20 -80 A.

The voltage selector 26 of the power stage has a three-level T-type NPC topology and is configured to provide three voltage levels at the selector output node N, thereby avoiding an operation state where a low gate voltage v_{g} of the backporch operation has to be formed by a close to 50-percent duty cycle operation which would in turn require a relatively high switching frequency to keep the gate current i_{g} ripple low. The gate control unit 23 controls the operation of the GCT 21 basically based on a comparator value of the gate voltage v_{g} and the measurement of the power stage 25 current e.g. based on a shunt and a current sense amplifier.

By applying the high supply potential Vₚₒₛ to the selector output node N, a voltage drop over the nonlinear inductor 27 is generated. This is made for a delay time of several microseconds to build up an inductor current iₒₙ in nonlinear inductor 27. After the turn-on delay, the turn-off stage is finally deactivated, and the inductor current iₒₙ is rapidly commutated into the gate terminal generating the turn-on pulse. After that, the middle supply voltage V_{mid} is applied to decrease the gate current i_{g} to its backporch value when the gate voltage v_{g} is measured positive. When the gate voltage v_{g} is measured negative, the low supply voltage is applied to ensure that the gate current decreases after the initial pulse as this can be understood as a sign that the antiparallel diode of the gate-commutated thyristor is conducting. After the gate current i_{g} has reached the desired backporch current value, the backporch operation state is activated depending on the polarity of the gate voltage v_{g}.

When the nonlinear inductor 27 has a nonlinearity to have an inductance sufficiently high during the backporch operation to ensure that an acceptable low current ripple can be achieved at a switching frequency appropriately low and that the inductance is sufficiently low to ensure a fast ramp-up of the gate current i_{g} to generate and propagate the high slope current at turn-on pulse generation and retrigger pulse generation. As these conditions are associated with different current regimes of the inductor current, the nonlinear saturable inductor is used that decreases its inductance with increasing currents.

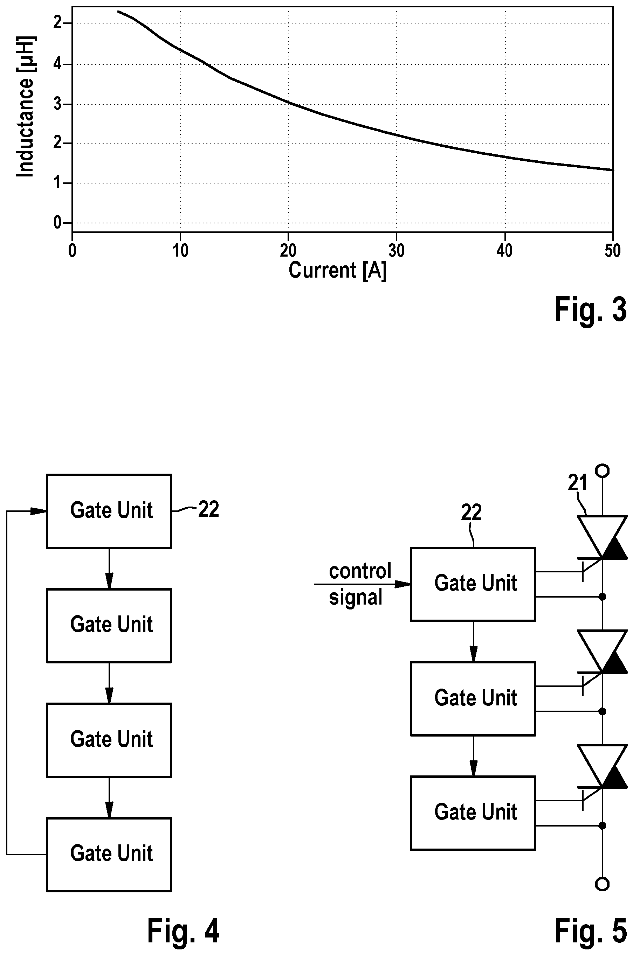

An exemplary characteristics of the nonlinear inductor is shown in Figure 3 wherein inductor 27 has a current dependency where the inductance decreases as the current rises.

Preferably, the nonlinearity is selected so that the low inductance for the turn-on pulse generation has a value at least 50 % lower than the high inductance during the backporch operation.

With reference to Figure 4, in a switching system such as a converter system 1 as shown in Figure 1 gate units 22 may be provided with an interlock function, which may be implemented as an independent function in each of the gate units 22. The idea is to provide an additional communication channel 29, such as fiber optics, on the gate units 22 that allows for interlocking the gate units in the case of an error detection in one of the gate units 22. The idea is to make an unidirectional ring structure capable of propagating the error state through the gate units 22 without involvement of the central controller 5.

As shown in Figure 4 information about error is propagated via all gate units 22. By default all gate units 22 are in no error state and send a corresponding signal but when an error in some gate unit 22 is recognized, this gate unit 22 starts to transmit an error signal. The gate unit 22 that receives an error signal also goes into an error state. Hence, the error signal is propagated rapidly through all units effectively interlocking the converter and reducing a change of a follow-up failure.

The advantage of this approach is that central controller 5 does not require to possess many fiber optic inputs to get an error state from every single gate unit 22 to disable the application. Moreover, the length of the utilized optical fiber could be shorter, considering that the fiber optic interconnections are only within the IGCT stack.

Furthermore, as shown in Figure 5 an interlink between the series-connected IGCTs 21, 22 is provided to simplify the cabling of optical fibers within the application. This approach is configured by an additional communication channel output on each gate unit 22 to enable an option for an interlink. Here, gate units 22 propagate the control signal which controls the switching of the IGCTs and only one connection to the central controller 5 is necessary. This significantly simplifies the cabling of the communication channels and also requires lower number of communication outputs at the central controller 5.

Since the turn-on and turn-off need to happen in all IGCTs at the same time, it is recommended to wait for a certain amount of time in each device to compensate for the propagation delays due to communication transmitters and receivers (e.g. 30 ns in first device, 20 ns in second and 10 ns in third, assuming the propagation delay of 10 ns per gate unit). The particular waiting time for each IGCT can either be configured manually or it can be programmed to happen automatically during converter power up. This could be implemented by propagating the number via the interlink chain, which would be increased in each gate unit. This would provide sufficient information on how much time has to be waited in the particular IGCT.

## Claims

1. Gate unit (22) for controlling a gate commutated thyristor (21), comprising:
- a voltage selector (26) for selectively applying a high supply potential (Vₚₒₛ), a middle supply potential (V_{mid}), and a low supply potential (V_{neg}) to an output of the voltage selector (26);
- a nonlinear inductor (27) serially coupled between the output of the voltage selector (26) and a gate terminal of the gate commutated thyristor (21);
- a gate control unit (23) configured to control the voltage selector (26) to control switching of the gate commutated thyristor (21) in its turn-on state comprising a turn-on pulse generation, a positive-gate-voltage backporch operation, a negative-gate-voltage backporch operation and a retrigger pulse generation, wherein in the positive-gate-voltage backporch operation a current is supplied to the gate terminal of the gate commutated thyristor to ensure that the thyristor cells remain in the on-state, wherein in the negative-gate-voltage backporch operation a current is supplied to keep the gate commutated thyristor turned-on, while a gate voltage of the gate commutated thyristor is negative;
wherein the nonlinear inductor (27) has a nonlinearity to have a high inductance during any of the backporch operations and to have a low inductance during the turn-on pulse generation and retrigger pulse generation,
wherein the gate control unit (23) is configured to operate switching of the gate commutated thyristor (21) in soft-switching mode, particularly in a zero voltage switching mode or a zero current switching mode.

2. Gate unit (22) according to claim 1, wherein the voltage selector (26) is configured as a transistor switched voltage selector such as a three level NPC circuit.

3. Gate unit (22) according to any of the claims 1 to 2, wherein the gate control unit (23) is configured to control the voltage selector (26) for the positive-gate-voltage backporch operation by controlling an inductor current through the nonlinear inductor (27) via pulses generated by applying two supply potentials in an alternating manner as long as a measured gate-to-cathode voltage of the gate commutated thyristor (21) is positive.

4. Gate unit (22) according to any of the claims 1 to 3, wherein the gate control unit (23) is configured to control the voltage selector (26) for the negative-gate-voltage backporch operation by controlling an inductor current through the nonlinear inductor (27) via pulses generated by applying two supply potentials in an alternating manner as long as a measured gate-to-cathode voltage of the gate commutated thyristor (21) is negative.

5. Gate unit (22) according to any of the claims 1 to 4, wherein a turn-off stage (28) is provided configured to apply the negative supply potential (V_{neg}) to the gate of the gate commutated thyristor (21) to selectively turn off the gate commutated thyristor (21).

6. Gate unit (22) according to claim 5, wherein the gate control unit is configured to, in the turn-on operation, keeping the negative supply potential (V_{neg}) applied by means of the turn off stage while applying the high supply potential (Vₚₒₛ) or the middle supply potential (V_{mid}) to increase an inductor current of the nonlinear inductor, while after a given time delay, the turn off stage (28) is deactivated so that the inductor current is fully commutated as gate current ig into a gate terminal (G) of the gate commutated thyristor (21), wherein after an inductor current (iₒₙ) has been commutated into the gate terminal (G) , the middle supply potential (V_{mid}) is applied.

7. Gate unit (22) according to any of the claims 1 to 6, wherein nonlinearity of the nonlinear inductor (27) is selected so that the low inductance for the turn-on pulse generation has a value at least 50 % lower than the high inductance during the backporch operation.

8. Gate unit (22) according to any of the claims 1 to 7, comprising a communication channel output to interlink with a control input of another gate unit (22) wherein the gate control unit (23) is configured to propagate a control signal received via the control input through the communication channel output, wherein the control signal includes switching commands for the gate commutated thyristors (21).

9. Gate unit (22) according to any of the claims 1 to 8, comprising a communication channel output to interlink with a control input of another gate unit (22) wherein the gate control unit (23) is configured to propagate a control signal received via the control input through the communication channel output, wherein the control signal includes an error signal indicating the occurrence of an error in one of the gate units (22) wherein the gate control unit (23) is further configured to halt operation of the gate unit once an error signal has been received.

10. Integrated gate commutated thyristor comprising a gate commutated thyristor (21) and the gate unit (22) according to any of the claims 1 to 8.

11. Converter stage (2) for use in a converter system (1), comprising a number of integrated gate commutated thyristors each including a gate commutated thyristor (21) and the gate unit (22) according to claim 8 or 9, wherein one of the gate units (22) is coupled with a central controller (5) to receive the control signal and at least a part of the other gate units (22) are respectively coupled via its communication channel output with the control input of a further one of the other gate units (22), so that the control signal is available in all gate units (22).

12. Use of the integrated gate commutated thyristor according to claim 10 in a converter stage (2) of a converter system (1).

13. Method for operating a gate commutated thyristor (21) using a gate unit (22) according to any of the claims 1 to 9.

## Patentansprüche

1. Gate-Einheit (22) zum Steuern eines Gate-Kommutierungs-Thyristors (21), umfassend:
- einen Spannungswähler (26) zum selektiven Anlegen eines hohen Versorgungspotentials (Vₚₒₛ), eines mittleren Versorgungspotentials (V_{mid}) und eines niedrigen Versorgungspotentials (V_{neg}) an einen Ausgang des Spannungswählers (26);
- einen nichtlinearen Induktor (27), der in Reihe zwischen dem Ausgang des Spannungswählers (26) und einem Gate-Anschluss des Gate-kommutierten Thyristors (21) geschaltet ist;
- eine Gate-Steuereinheit (23), die so konfiguriert ist, dass sie den Spannungswähler (26) steuert, um das Schalten des gate-kommutierten Thyristors (21) in seinem Einschaltzustand zu steuern, der eine Einschaltimpulserzeugung, einen Positive-Gate-Spannungs-Backporch-Betrieb, einen Negative-Gate-Spannungs-Backporch-Betrieb und eine Retrigger-Impulserzeugung umfasst, wobei im Positive-Gate-Spannungs-Backporch-Betrieb ein Strom an den Gate-Anschluss des Gate-Kommutierungs-Thyristors angelegt wird, um sicherzustellen, dass die Thyristorzellen im eingeschalteten Zustand bleiben, wobei im Negative-Gate-Spannungs-Backporch-Betrieb ein Strom angelegt wird, um den Gate-Kommutierungsthyristor eingeschaltet zu halten, während eine Gate-Spannung des Gate-Kommutierungsthyristors negativ ist;
wobei der nichtlineare Induktor (27) eine Nichtlinearität aufweist, um während eines beliebigen der Backporch-Betriebe eine hohe Induktivität und während der Einschaltimpulserzeugung und der Retriggerimpulserzeugung eine niedrige Induktivität zu haben,
wobei die Gate-Steuereinheit (23) so konfiguriert ist, dass sie das Schalten des Gate-Kommutierungs-Thyristors (21) im Soft-Switching-Modus betreibt, insbesondere in einem Nullspannungsschaltmodus oder einem Nullstromschaltmodus.

2. Gate-Einheit (22) nach Anspruch 1, wobei der Spannungswähler (26) als transistorgeschalteter Spannungswähler, beispielsweise als Dreipunkt-NPC-Schaltung, ausgebildet ist.

3. Gate-Einheit (22) nach einem der Ansprüche 1 bis 2, wobei die Gate-Steuereinheit (23) so konfiguriert ist, dass sie den Spannungswähler (26) für den Positive-Gate-Spannungs-Backporch-Betrieb zu steuern, indem sie einen Induktionsstrom durch den nichtlinearen Induktor (27) über Impulse steuert, die durch abwechselndes Anlegen von zwei Versorgungsspannungen erzeugt werden, solange eine gemessene Gate-Kathoden-Spannung des Gate-Kommutierungs-Thyristors (21) positiv ist.

4. Gate-Einheit (22) nach einem der Ansprüche 1 bis 3, wobei die Gate-Steuereinheit (23) so konfiguriert ist, dass sie den Spannungswähler (26) für den Negative-Gate-Spannungs-Backporch-Betrieb zu steuern, indem ein Induktionsstrom durch die nichtlineare Induktivität (27) über Impulse gesteuert wird, die durch abwechselndes Anlegen von zwei Versorgungspotentialen erzeugt werden, solange eine gemessene Gate-Kathoden-Spannung des Gate-Kommutierungs-Thyristors (21) negativ ist.

5. Gate-Einheit (22) nach einem der Ansprüche 1 bis 4, wobei eine Ausschaltstufe (28) vorgesehen ist, die so konfiguriert ist, dass sie das negative Versorgungspotential (Vneg) an das Gate des Gate-Kommutierungs-Thyristors (21) anlegt, um den Gate-Kommutierungs-Thyristor (21) selektiv auszuschalten.

6. Gate-Einheit (22) nach Anspruch 5, wobei die Gate-Steuereinheit so konfiguriert ist, dass sie im Einschaltvorgang das negative Versorgungspotential (Vneg) mittels der Abschaltstufe aufrechterhält, während sie das hohe Versorgungspotential (Vpos) oder das mittlere Versorgungspotential (Vmid) anlegt, um einen Induktionsstrom des nichtlinearen Induktors zu erhöhen, während nach einer bestimmten Zeitverzögerung die Ausschaltstufe (28) deaktiviert wird, so dass der Induktionsstrom vollständig als Gate-Strom ig in einen Gate-Anschluss (G) des Gate-Kommutierungs-Thyristors (21) kommutiert wird, wobei nach der Kommutierung eines Induktionsstroms (iₒₙ) in den Gate-Anschluss (G) das mittlere Versorgungspotential (V_{mid}) angelegt wird.

7. Gate-Einheit (22) nach einem der Ansprüche 1 bis 6, wobei die Nichtlinearität des nichtlinearen Induktors (27) so gewählt ist, dass die niedrige Induktivität für die Einschaltimpulserzeugung einen Wert hat, der mindestens 50 % niedriger ist als die hohe Induktivität während des Backporch-Betriebs.

8. Gate-Einheit (22) nach einem der Ansprüche 1 bis 7, mit einem Kommunikationskanalausgang zur Verbindung mit einem Steuereingang einer anderen Gate-Einheit (22), wobei die Gate-Steuereinheit (23) so konfiguriert ist, dass sie ein über den Steuereingang empfangenes Steuersignal über den Kommunikationskanalausgang weiterleitet, wobei das Steuersignal Schaltbefehle für die Gate-Kommutierungs-Thyristoren (21) enthält.

9. Gate-Einheit (22) nach einem der Ansprüche 1 bis 8, mit einem Kommunikationskanalausgang zur Verbindung mit einem Steuereingang einer anderen Gate-Einheit (22) zu verbinden, wobei die Gate-Steuereinheit (23) so konfiguriert ist, dass sie ein über den Steuereingang empfangenes Steuersignal über den Kommunikationskanalausgang weiterleitet, wobei das Steuersignal ein Fehlersignal enthält, das das Auftreten eines Fehlers in einer der Gate-Einheiten (22) anzeigt, wobei die Gate-Steuereinheit (23) ferner so konfiguriert ist, dass sie den Betrieb der Gate-Einheit stoppt, sobald ein Fehlersignal empfangen wurde.

10. Integrierter Gate-Kommutierungs-Thyristor, umfassend einen Gate-Kommutierungs-Thyristor (21) und die Gate-Einheit (22) gemäß einem der Ansprüche 1 bis 8.

11. Umrichterstufe (2) zur Verwendung in einem Umrichtersystem (1), mit einer Anzahl integrierter Gate-Kommutierungs-Thyristoren, die jeweils einen Gate-Kommutierungs-Thyristor (21) und die Gateeinheit (22) gemäß Anspruch 8 oder 9 umfassen, wobei eine der Gateeinheiten (22) mit einer zentralen Steuereinheit (5) gekoppelt ist, um das Steuersignal zu empfangen, und mindestens ein Teil der anderen Gate-Einheiten (22) jeweils über seinen Kommunikationskanalausgang mit dem Steuereingang einer weiteren der anderen Gate-Einheiten (22) gekoppelt ist, so dass das Steuersignal in allen Gate-Einheiten (22) verfügbar ist.

12. Verwendung des integrierten Gate-Kommutierungs-Thyristors gemäß Anspruch 10 in einer Umrichterstufe (2) eines Umrichtersystems (1).

13. Verfahren zum Betreiben eines Gate-Kommutierungs-Thyristors (21) unter Verwendung einer Gate-Einheit (22) gemäß einem der Ansprüche 1 bis 9.

## Revendications

1. Unité de commande (22) pour commander un thyristor à commutation par grille (21), comprenant :
- un sélecteur de tension (26) pour appliquer de manière sélective un potentiel d'alimentation élevé (Vₚₒₛ), un potentiel d'alimentation moyen (V_{mid}) et un potentiel d'alimentation faible (V_{neg}) à une sortie du sélecteur de tension (26) ;
- une inductance non linéaire (27) couplée en série entre la sortie du sélecteur de tension (26) et une borne de gâchette du thyristor à commutation par grille (21) ;
- une unité de commande de grille (23) configurée pour commander le sélecteur de tension (26) afin de commander la commutation du thyristor à commutation par grille (21) dans son état activé, comprenant une génération d'impulsion d'activation, une opération de backporch à tension de grille positive, une opération de backporch à tension de grille négative et une génération d'impulsion de redéclenchement, dans laquelle, dans l'opération de backporch à tension de grille positive, un courant est fourni à la borne de grille du thyristor à commutation par grille afin de garantir que les cellules du thyristor restent à l'état activé, dans laquelle, dans l'opération de backporch à tension de grille négative, un courant est fourni à la borne de grille du thyristor à commutation par grille afin de garantir que les cellules du thyristor restent à l'état activé, dans laquelle, dans l'opération de backporch à tension de grille positive, un courant est fourni à la borne de grille du thyristor à commutation par grille afin de garantir que les cellules du thyristor restent à l'état activé, dans laquelle, dans l'opération de backporch à opération de backporch à tension de grille positive, un courant est fourni à la borne de grille du thyristor à commutation de grille pour garantir que les cellules du thyristor restent à l'état activé, dans lequel, dans l'opération de backporch à tension de grille négative, un courant est fourni pour maintenir le thyristor à commutation de grille activé, tandis qu'une tension de grille du thyristor à commutation de grille est négative ;
dans lequel l'inductance non linéaire (27) présente une non-linéarité pour avoir une inductance élevée pendant l'un quelconque des modes de fonctionnement en backporch et pour avoir une inductance faible pendant la génération d'impulsion d'activation et la génération d'impulsion de redéclenchement,
dans lequel l'unité de commande de grille (23) est configurée pour commander la commutation du thyristor à commutation par grille (21) en mode de commutation douce, en particulier dans un mode de commutation à tension nulle ou un mode de commutation à courant nul.

2. Unité de grille (22) selon la revendication 1, dans laquelle le sélecteur de tension (26) est configuré comme un sélecteur de tension commuté par transistor, tel qu'un circuit NPC à trois niveaux.

3. Unité de grille (22) selon l'une quelconque des revendications 1 à 2, dans laquelle l'unité de commande de grille (23) est configurée pour commander le sélecteur de tension (26) pour l'opération de backporch de tension de grille positive fonctionnement en backporch de tension de grille positive en commandant un courant d'inductance à travers l'inductance non linéaire (27) via des impulsions générées en appliquant deux potentiels d'alimentation de manière alternée tant que la tension mesurée entre la grille et la cathode du thyristor à commutation de grille (21) est positive.

4. Unité de grille (22) selon l'une quelconque des revendications 1 à 3, dans laquelle l'unité de commande de grille (23) est configurée pour commander le sélecteur de tension (26) pour le fonctionnement en backporch à tension de grille négative en contrôlant un courant d'inductance à travers l'inductance non linéaire (27) via des impulsions générées en appliquant deux potentiels d'alimentation de manière alternée tant que la tension mesurée entre la grille et la cathode du thyristor à commutation par grille (21) est négative.

5. Unité de grille (22) selon l'une quelconque des revendications 1 à 4, dans laquelle un étage de coupure (28) est prévu, configuré pour appliquer le potentiel d'alimentation négatif (Vneg) à la grille du thyristor à commutation de grille (21) afin de couper sélectivement le thyristor à commutation de grille (21).

6. Unité de grille (22) selon la revendication 5, dans laquelle l'unité de commande de grille est configurée pour, dans l'opération d'activation, maintenir le potentiel d'alimentation négatif (V_{neg}) appliqué au moyen de l'étage de désactivation tout en appliquant le potentiel d'alimentation élevé (Vₚₒₛ) ou le potentiel d'alimentation moyen (V_{mid}) afin d'augmenter un courant d'inductance de l'inductance non linéaire, tandis qu'après un délai donné, l'étage de coupure (28) est désactivé de sorte que le courant d'inductance est entièrement commuté en tant que courant de gâchette ig dans une borne de gâchette (G) du thyristor à commutation par gâchette (21), dans lequel, après qu'un courant d'inductance (ion) a été commuté dans la borne de gâchette (G), le potentiel d'alimentation moyen (Vmid) est appliqué.

7. Unité de grille (22) selon l'une quelconque des revendications 1 à 6, dans laquelle la non-linéarité de l'inductance non linéaire (27) est sélectionnée de telle sorte que la faible inductance pour la génération d'impulsion d'activation ait une valeur au moins 50 % inférieure à la forte inductance pendant le fonctionnement en backporch.

8. Unité de grille (22) selon l'une quelconque des revendications 1 à 7, comprenant une sortie de canal de communication pour s'interconnecter avec une entrée de commande d'une autre unité de porte (22), dans laquelle l'unité de commande de porte (23) est configurée pour propager un signal de commande reçu via l'entrée de commande à travers la sortie de canal de communication, dans laquelle le signal de commande comprend des commandes de commutation pour les thyristors à commutation par grille (21).

9. Unité de grille (22) selon l'une quelconque des revendications 1 à 8, comprenant une sortie de canal de communication pour interconnecter une entrée de commande d'une autre unité de grille (22), dans laquelle l'unité de commande de grille (23) est configurée pour propager un signal de commande reçu via l'entrée de commande à travers la sortie du canal de communication, dans laquelle le signal de commande comprend un signal d'erreur indiquant la survenue d'une erreur dans l'une des unités de grille (22), dans laquelle l'unité de grille (23) est en outre configurée pour arrêter le fonctionnement de l'unité de grille une fois qu'un signal d'erreur a été reçu.

10. Thyristor à commutation par grille intégré comprenant un thyristor à commutation par grille (21) et l'unité de gâchette (22) selon l'une quelconque des revendications 1 à 8.

11. Étage convertisseur (2) destiné à être utilisé dans un système convertisseur (1), comprenant un certain nombre de thyristors à commutation par grille intégrés comprenant chacun un thyristor à commutation par grille (21) et l'unité de gâchette (22) selon la revendication 8 ou 9, dans lequel l'une des unités de gâchette (22) est couplée à un contrôleur central (5) pour recevoir le signal de commande et au moins une partie des autres unités de grille (22) sont respectivement couplées via sa sortie de canal de communication à l'entrée de commande d'une autre des autres unités de grille (22), de sorte que le signal de commande est disponible dans toutes les unités de grille (22).

12. Utilisation du thyristor à commutation par grille intégrée selon la revendication 10 dans un étage convertisseur (2) d'un système convertisseur (1).

13. Procédé pour faire fonctionner un thyristor à commutation par grille (21) à l'aide d'une unité de gâchette (22) selon l'une quelconque des revendications 1 à 9.
